# EUROPEAN PATENT SPECIFICATION

(11) **EP 0 347 195 B1**
(45) Date of publication and mention of the grant of the patent: **16.03.1994**
(21) Application number: 89306002.0
(22) Date of filing: 14.06.1989
(51) Int. Cl.: H01L 27/02, H03M 1/06

(54) **Input protection circuit for analog/digital converting semiconductor integrated circuit**
Eingangsschutzschaltung für Analog/Digital integrierte Halbleiterumsetzerschaltung
Circuit de protection d'entrée pour circuit semi-conducteur intégré de conversion analogique/numérique

(30) Priority: 14.06.1988 JP 147205/88
(43) Date of publication of application: 20.12.1989
(73) Proprietor: NEC CORPORATION, Tokyo (JP)
(72) Inventor: Hinooka, Kiyonobu c/o NEC Corporation, Tokyo (JP)
(74) Representative: Brown, David Alan

(56) References cited:
- US-A- 4 691 217
- US-A- 4 694 315
- PATENT ABSTRACTS OF JAPAN vol. 11, no. 59 (E-482)(2506) 24 February 1987, & JP-A-61 218163
- ELECTRICAL OVERSTRESS/ELECTROSTATIC DISCHARGE SYMPOSIUM September 1980, CALIFORNIA pages 73 - 80; J. K. KELLER: "PROTECTION OF MOS INTEGRATED CIRCUITS FROM DESTRUCTION BY ELECTROSTATIC DISCHARGE".

## Description

### Background of the Invention

### Field of the invention

The present invention relates to an analog/digital converting semiconductor integrated circuit, and more specifically to an improved layout of an input protection circuit for an analog/digital (A/D) converter in the form of an integrated circuit composed of complementary metal-oxide-semiconductor (MOS) transistors formed on a semiconductor substrate.

### Description of related art

Recently, A/D converters which are composed of complementary MOS transistors formed on a semiconductor substrate have been improved to realize a high speed operation and a high precision. On the other hand, the A/D converters have been often used in a noisy environment, for example for control of engines of automobiles. In many cases, the A/D converter has a plurality of selectable analog input channels. In the case that the A/D converter having a plurality of selectable analog input channels is used in the noisy environment, noise will intrude from a non-selected analog input channel into a selected analog input channel, with the result that the precision of the A/D conversion will remarkably decrease.

This adverse influence to the A/D conversion precision due the noise will become further remarkable if the A/D convertor has a higher conversion precision. At present, it is estimated that the A/D conversion precision will be made further higher in the future, and therefore, the adverse influence of noise will become more significant. In the A/D converter, accordingly, it is an important current problem awaiting to be solved, to effectively suppress the influence of a noise intruding from a non-selected channel.

### Summary of the Invention

Accordingly, it is an object of the present invention to provide an A/D converter which overcomes the above mentioned defect of the conventional one.

Another object of the present invention is to provide an input protection circuit for an A/D converter having a plurality of input channels, capable of effectively preventing the influence of a noise intruded from a non-selected channel.

The above and other objects of the present invention are achieved in accordance with the present invention by a semiconductor integrated circuit with an input circuit as specified in claim 1 and by an A/D converter in the form of a complementary MOS integrated circuit and having a plurality of input channels as specified in claim 4. The input circuit includes a plurality of input protection circuits corresponding to the input channels. Each of the input protection circuits comprises an analog input terminal to be connected to receive an analog voltage signal, and a first semiconductor active element formed within a first conduction type island formed in the semiconductor substrate. The first semiconductor active element has one end connected to the input terminal and a second end connected to a first wiring conductor for a positive voltage. The first semiconductor active element operates a discharge a positive excessive voltage to the first wiring conductor when the positive excessive voltage is applied to the input terminal. Each of the input protection circuits also comprises a second semiconductor active element formed within a second conduction type island formed in the semiconductor substrate, separately from the first island, the second conduction type being opposite to the first conduction type. The second semiconductor active element has one end connected to the input terminal and a second end connected to a second wiring conductor for ground. The second semiconductor active element operates to discharge a negative excessive voltage to the second wiring conductor when the negative excessive voltage is applied to the input terminal. The first semiconductor active elements and the second semiconductor active elements of all the input protection circuits are alternately located in the semiconductor substrate in such a manner that one first semiconductor active element is located between a pair of second semiconductor active elements and one second semiconductor active element is located between a pair of first semiconductor active elements.

The above and other objects, features and advantages of the present invention will be apparent from the following description of preferred embodiments of the invention with reference to the accompanying drawings.

### Brief Description of the Drawings

Figure 1 is a block diagram of a conventional A/D converter having a plurality of input channels;
Figures 2A and 2B are circuit diagrams showing typical conventional input protection circuits;
Figure 3 illustrates a layout pattern of the conventional input protection circuit;
Figure 4 is a diagrammatic sectional view taken along the line A-A in Figure 3;
Figure 5 is a diagrammatic sectional view taken along the line B-B in Figure 3;
Figure 6 illustrates a layout pattern of one embodiment of the input protection circuit in accordance with the present invention;
Figure 7 is a diagrammatic sectional view taken along the line C-C in Figure 6;
Figure 8 is a diagrammatic sectional view taken along the line D-D in Figure 6;
Figure 9 illustrates a layout pattern of another embodiment of the input protection circuit in accordance with the present invention.

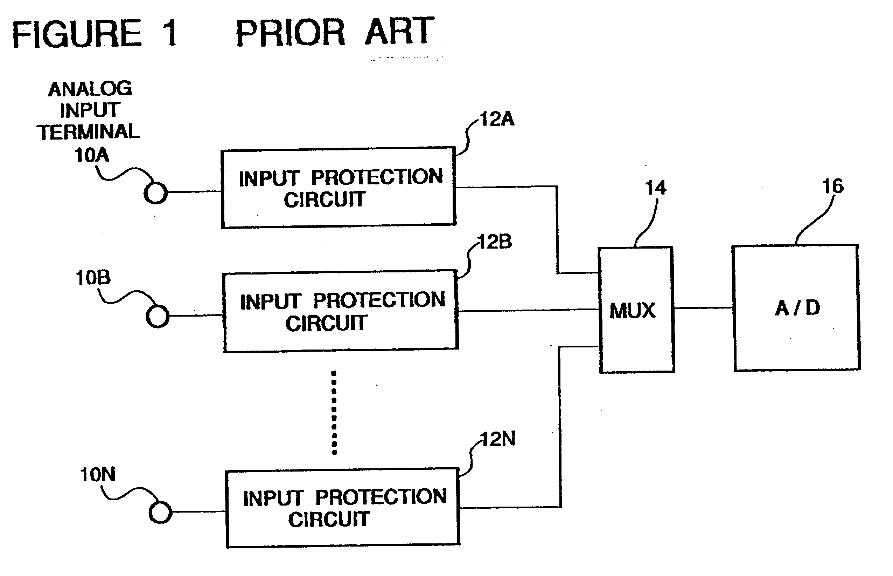

Referring to Figure 1, there is shown a diagram of an conventional A/D converter having a plurality of input channels. The shown A/D converter includes a plurality of analog input terminals 10A, 10B, ..., 10N, which are respectively connected to receive different analog signals. These input terminals 10A, 10B, ..., 10N are connected to inputs of a correspondingly number of input protection circuits 12A, 12B, ..., 12N, respectively. Outputs of the input protection circuits 12A, 12B, ..., 12N are coupled to a multiplexer 14, which is in turn connected at its output to an A/D converting circuit 16.

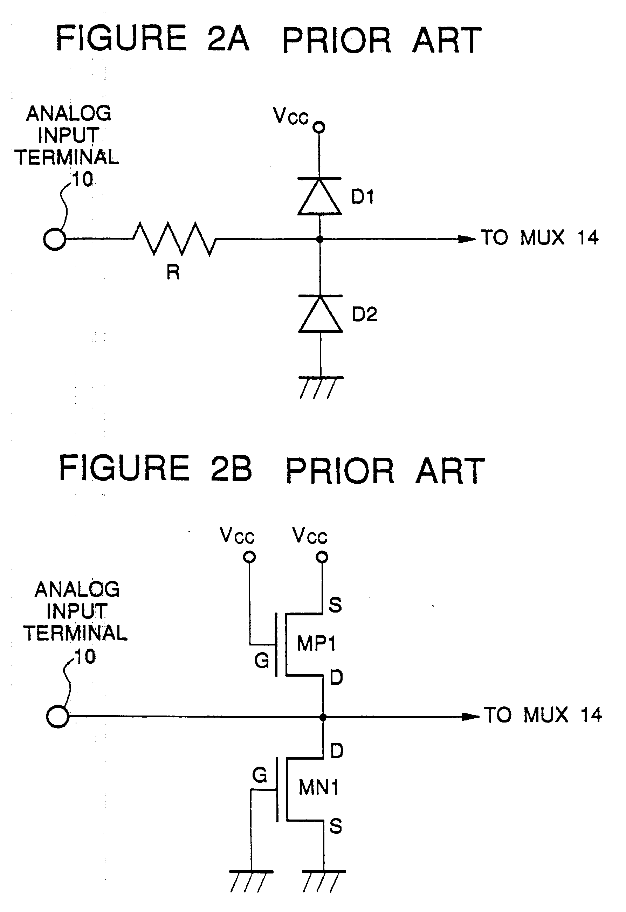

In the case that the above mentioned A/D converter is assembled in the form of a complementary MOS integrated circuit, each of the input protection circuits 12A, 12B, ..., 12N has been designed, for example, as shown in Figures 2A and 2B.

The input protection circuit shown in Figure 2A includes a resistor R having one end thereof connected to an analog input terminal 10. The other end of the resistor R is connected to a connection node between a pair of diodes D1 and D2 series-connected to each other in the same direction. The diode D1 whose anode is connected to the resistor R is connected at its cathode to a voltage supply potential Vcc, and the diode D2 whose cathode is connected to the resistor R is connected at its anode to ground. The connection node between the pair of diodes D1 and D2 is connected to a corresponding one input of the multiplexer 14 shown in Figure 1.

The input protection circuit shown in Figure 2B includes a p-channel transistor MP1 and an n-channel transistor MN1 having their drains commonly connected to the analog input terminal 10. A gate and a source of the p-channel transistor MP1 are connected to a voltage supply potential Vcc, and a gate and a source of the n-channel transistor MN1 are connected to ground. Therefore, the two transistors are maintained off unless an excessive positive or negative voltage is inputted to the input terminal. The commonly connected drains of the p-channel transistor MP1 and the n-channel transistor MN1 are connected to a corresponding one input of the multiplexer 14 shown in Figure 1.

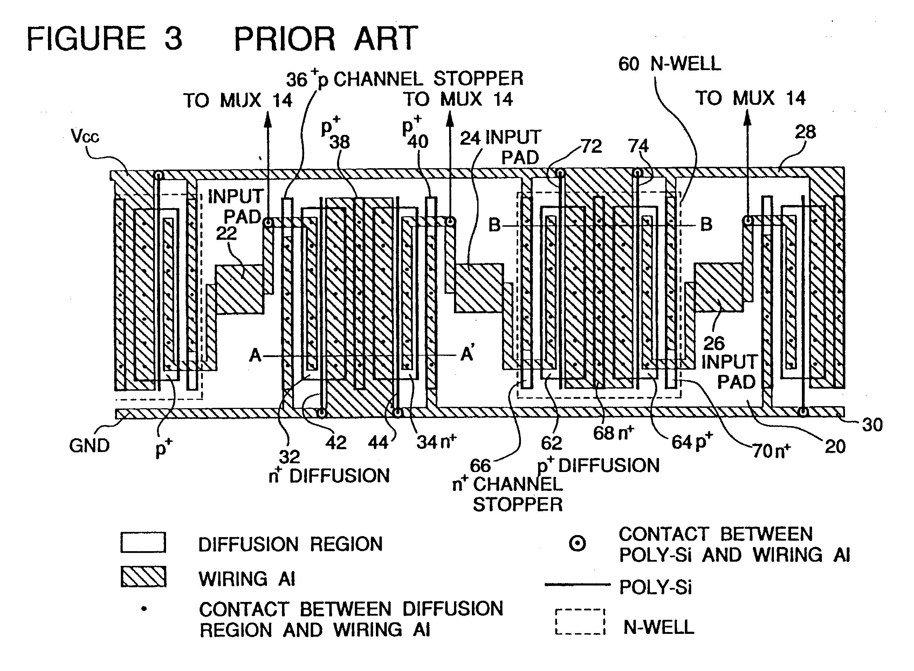

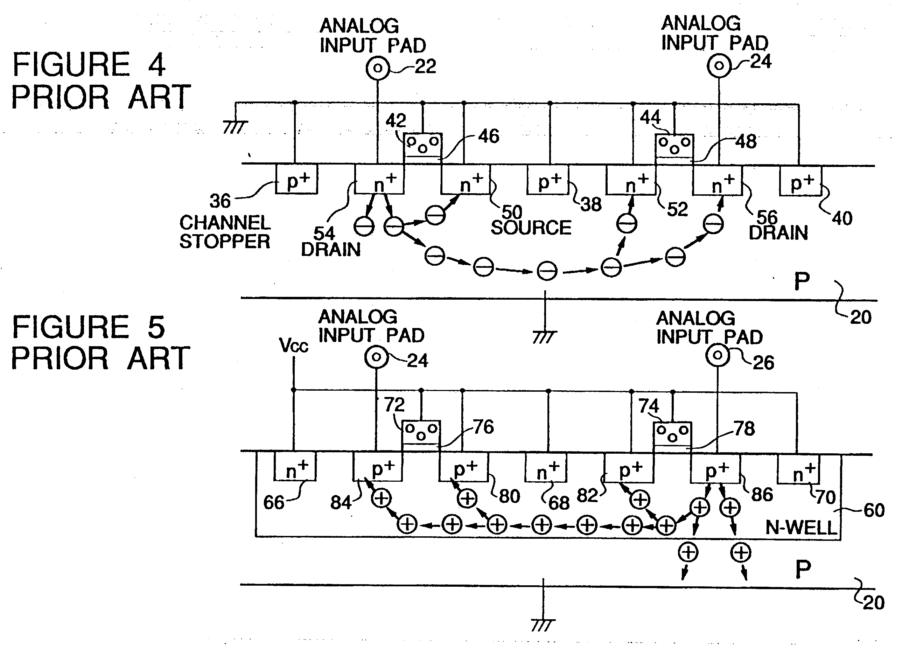

For example, if the input protection circuit shown in Figure 2B are laid out on a semiconductor substrate, a layout pattern shown in Figure 3 has been often adopted in the prior art. Furthermore, diagrammatic sectional views taken along the line A-A and the line B-B in Figure 3 are shown in Figures 4 and 5, respectively.

Namely, the shown circuit includes a P-type semiconductor substrate 20 and three analog input pads 22, 24 and 26 formed thereon separately from one another. Required p-channel transistors and n-channel transistors are arranged in such a manner that each input pad has at its one side one associated p-channel transistor connected thereto and at its other side one associated n-channel transistor connected thereto, and a pair of n-channel transistors are located between a pair of adjacent input pads (22 and 24) and a pair of p-channel transistors are located between another pair of adjacent input pads (24 and 26).

The substrate 20 includes a wiring conductor 28 made of for example aluminum and deposited along an upper edge of the substrate for a voltage supply potential Vcc, and another wiring conductor 30 of aluminum deposited along a lower edge of the substrate for ground GND.

Between the input pads 22 and 24, there are formed a pair of n⁺ diffusion regions 32 and 34 which are separated or confined by channel stoppers 36, 38 and 40 formed of p⁺ diffusion regions. Gate electrodes 42 and 44 are respectively formed through gate insulators 46 and 48 on the n⁺ diffusion regions 32 and 34 to vertically extend on a center of the n⁺ diffusion regions. Each of the gate electrodes 42 and 44 is formed of a polysilicon layer which extends to the ground aluminum wiring conductor 30 and is connected to the ground aluminum wiring conductor 30 by a contact shown by a center dotted small circle in Figure 3. The channel stoppers 36, 38 and 40, a portion 50 of the n⁺ diffusion region 32 positioned at a right side of the gate electrode 42, and a portion 52 of the n⁺ diffusion region 34 positioned at a left side of the gate electrode 44 are covered by a wiring conductor extending from the ground conductor 30. The diffusion regions 32, 34, 36, 38 and 40 and the covering aluminum ground wiring conductor are interconnected by a plurality of contacts shown by dots in Figure 3. In addition, a portion 54 of the n⁺ diffusion region 32 positioned at a left side of the gate electrode 42, and a portion 56 of the n⁺ diffusion region 34 positioned at a right side of the gate electrode 44 are covered by a wiring conductors extending to the input pads 22 and 24, respectively. The diffusion regions 32 and 34 and the covering aluminum wiring conductor are interconnected by a plurality of contacts shown by dots in Figure 3. With this arrangement, the portions 50 and 52 form source regions of the n-channel transistors connected to the ground, respectively and portions 54 and 56 form a drain region of the n-channel transistors connected to the input pads 22 and 24, respectively.

Between the input pads 24 and 26, there is formed a n-well 60 is formed, in which a pair of p⁺ diffusion regions 62 and 64 which are separated or confined by channel stoppers 66, 68 and 70 formed of n⁺ diffusion regions. Gate electrodes 72 and 74 are formed through gate insulators 76 and 78 on the p⁺ diffusion regions 62 and 64 to vertically extend on a center of the p⁺ diffusion regions. Each of the gate electrodes 72 and 74 is formed of a polysilicon layer which extends to the Vcc aluminum wiring conductor 28 and is connected to the Vcc aluminum wiring conductor 28 by a contact shown by a center dotted small circle in Figure 3. The channel stoppers 66, 68 and 70, a portion 80 of the p⁺ diffusion region 62 positioned at a right side of the gate electrode 72, and a portion 82 of the p⁺ diffusion region 64 positioned at a left side of the gate electrode 74 are covered by a wiring conductor extending from the Vcc wiring conductor 28. The diffusion regions 62, 64, 66, 68 and 70 and the covering aluminum Vcc wiring conductor are interconnected by a plurality of contacts shown by dots in Figure 3. In addition, a portion 84 of the p⁺ diffusion region 62 positioned at a left side of the gate electrode 72, and a portion 76 of the p⁺ diffusion region 64 positioned at a right side of the gate electrode 74 are covered by a wiring conductors extending to the input pads 24 and 26, respectively. The diffusion regions 62 and 64 and the covering aluminum wiring conductor are interconnected by a plurality of contacts shown by dots in Figure 3. With this arrangement, the portions 80 and 82 form source regions of the p-channel transistors connected to the ground, respectively, and portions 84 and 86 form a drain region of the p-channel transistors connected to the input pads 24 and 26, respectively.

When the A/D converter is actually used, one analog input channel is selected among a plurality of analog input channels, and the A/D converter converts into a digital signal an input analog voltage which is supplied from an input pad connected to the selected input channel. Now, assume that the analog input pad 24 is selected. In this condition, of course, the other input pads including the input pads 22 and 26 are not selected. However, if a noise having a voltage lower than a ground level is inputted to the input pad 22, the n⁺ diffusion drain region 54 connected to the input pad 22 is biased in a forward direction to the p-substrate 20 maintained at the ground level. Therefore, electrons are injected into the substrate 20 from the n⁺ diffusion drain region 54 as illustrated in Figure 4. These injected electrons will be absorbed by the other n⁺ diffusion regions 50, 52 and 56 by a bipolar action. A portion of the electrons absorbed by the n⁺ diffusion regions 50 and 52 will further flow into the ground GND having a low impedance, and therefore, will not give any influence on the A/D conversion operation. However, a portion of the electrons absorbed by the n⁺ diffusion region 56 connected to the selected input pad 24 will cause an error in the A/D conversion. In many cases, the analog input wirings are connected in series with a protective resistor of 10 KΩ to 100 KΩ located externally of the semiconductor integrated circuit. Namely, the analog input is not necessarily of a low impedance, and therefore, if the absorbed electrons has injected into the selected input pad, a potential drop will appear across the external protective resistor due to the flow of the absorbed electrons and is superimposed on the analog voltage signal inputted on the selected input pud 24. In other words, the voltage on the selected input pud 24 will become lower than that of a true analog signal inputted to the selected input pad. As a result, the decreased voltage is converted into a digital signal, which is no longer indicative of a digital value corresponding to the true analog signal inputted to the selected input pad. Namely, an error will occur in the A/D conversion.

On the other hand, assume that the analog input pad 24 is selected and a noise having a voltage higher than Vcc is inputted into the analog pad 26. If the voltage higher than Vcc is applied into the analog pad 26, the p⁺ diffusion region 86 connected to the analog pad 26 is biased in a forward direction to the N-well 60 maintained at the potential Vcc, and therefore, holes will be injected from the p⁺ diffusion region 86 to the N-well 60. These injected holes are diffused within the N-well 60, and a major portion of the injected holes will be further injected to the p-substrate 20. But, some portion of the injected holes will be absorbed to the p⁺ diffusion regions 82, 80 and 84 within the N-well 60. Holes absorbed to the p⁺ diffusion regions 82 and 80 will flow into the Vcc having a low impedance, and therefore, will not give an adverse influence to the A/D conversion. But, holes absorbed to the p⁺ diffusion region 84 connected to the selected input pad 24 will give an adverse influence to the A/D conversion. Namely, the potential of the input pad 24 will be brought to a potential higher thin a voltage of a true analog signal inputted to the selected input pad 24, and accordingly, an error of the A/D conversion will occur.

In the case that the input protection circuit composed of a pair of diodes D1 and D2 shown in Figure 2A is integrated on a semiconductor substrate, the diode D1 connected to Vcc is formed of a p⁺/n junction and the diode D2 connected to ground is formed of a n⁺/p junction. In the prior art, the p⁺/n diodes and the n⁺/p diodes have been arranged in such a manner that each input pad has at its one side one associated p⁺/n diode connected thereto and at its other side one associated n⁺/p diode connected thereto, and a pair of p⁺/n diodes are located adjacent to each other and a pair of n⁺/p diodes are located adjacent to each other so that the p⁺/n diode pairs and the p⁺/n diode pairs are alternately arranged. In this case, if a noise having a voltage lower than the ground level or higher than the Vcc level is inputted to a non-selected input pad, an A/D conversion an error will occur, similarly to the layout shown in Figure 3.

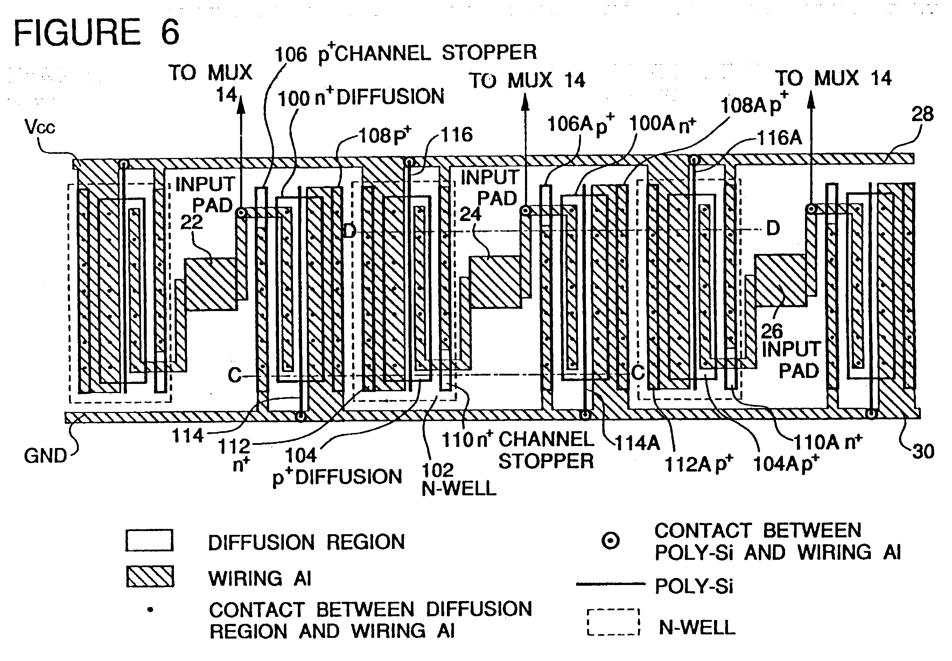

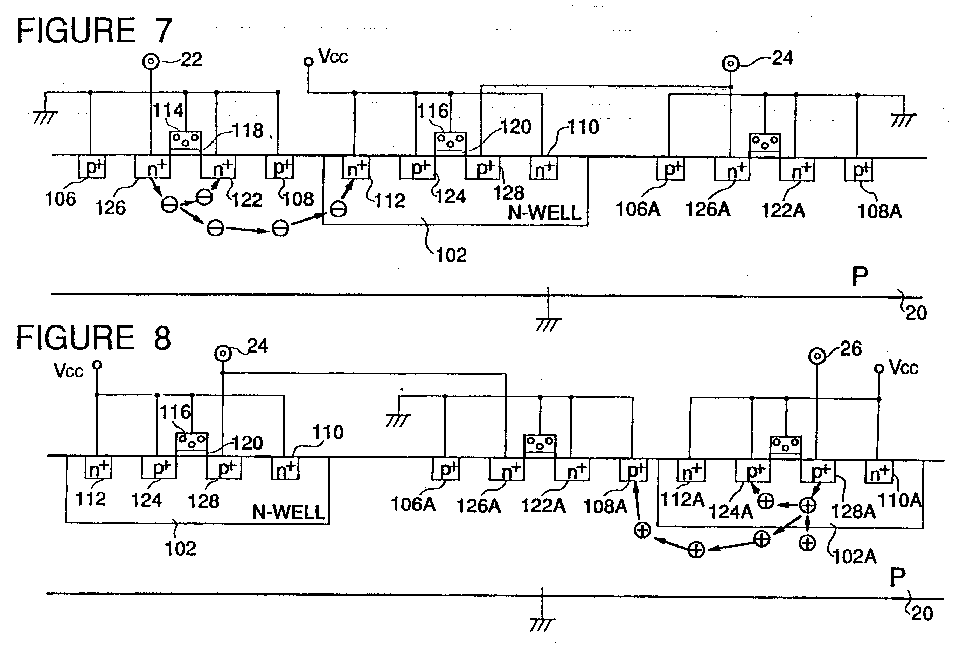

Referring to Figure 6, there is shown a layout pattern of one embodiment of the input protection circuit in accordance with the present invention. Figure 7 is a diagrammatic sectional view taken along the line C-C in Figure 6 and Figure 8 is a diagrammatic sectional view taken along the line D-D in Figure 6.

The layout pattern shown in Figure 5 realizes the input protection circuit shown in Figure 2B. In the shown layout pattern, each input pad has at its one side one associated p-channel transistor connected thereto and at its other side one associated n-channel transistor connected thereto, similarly to the layout shown in Figure 3, but a pair of n-channel transistor and p-channel transistor are located between each pair of adjacent input pads, in such a manner that one n-channel transistor is positioned between a pair of p-channel transistors and one p-channel transistor is positioned between a pair of n-channel transistors, differently from the layout shown in Figure 3.

The substrate 20 includes an aluminum wiring conductor 28 for a voltage supply potential Vcc and deposited along an upper edge of the substrate, and another aluminum wiring conductor 30 deposited along a lower edge of the substrate for ground GND.

Between a pair of adjacent input pads 22 and 24, one n⁺ diffusion region 100 and one N-well 102 having therein one p⁺ diffusion region 100 are formed separately from each other. A pair of channel stoppers 106 and 108 of p⁺ diffusion regions are formed on both sides of the n⁺ diffusion region 100. In addition, another pair of channel stoppers 110 and 112 of n⁺ diffusion regions are formed on both sides of the p⁺ diffusion region 104 within the N-well 102. Gate electrodes 114 and 116 are formed through gate insulators 118 and 120 on the n⁺ diffusion region 100 and the p⁺ diffusion region 104 to vertically extend on a center of these diffusion regions. The gate electrodes 114 and 116 are formed of a polysilicon layer. The gate electrode 114 extends to the ground aluminum wiring conductor 30 and is connected to the ground aluminum wiring conductor 30 by a contact shown by a center dotted small circle in Figure 6, and the gate electrode 116 extends to the Vcc aluminum wiring conductor 28 and is connected to the Vcc aluminum wiring conductor 28 by a contact shown by a center dotted small circle in Figure 6.

The channel stoppers 106 and 108, and a portion 122 of the n⁺ diffusion region 100 positioned at a right side of the gate electrode 114 are covered by a wiring conductor extending from the ground conductor 30. The diffusion regions 106, 108, and 100 and the covering aluminum ground wiring conductor are interconnected by a plurality of contacts shown by dots in Figure 6. The channel stoppers 110 and 112 and a portion 124 of the p⁺ diffusion region 104 positioned at a left side of the gate electrode 116 are covered by a wiring conductor extending from the Vcc wiring conductor 28. The diffusion regions 110 and 112 and the covering aluminum Vcc wiring conductor are interconnected by a plurality of contacts shown by dots in Figure 6.

In additon, a portion 126 of the n⁺ diffusion region 100 positioned at a left side of the gate electrode 114 is covered by a wiring conductor extending to the input pad 22. A portion 128 of the p⁺ diffuson region 104 positioned at a right side of the gate electrode 116 are covered by a wiring conductors extending to the input pad 24. The diffusion regions 100 and 104 and the covering aluminum wiring conductor are interconnected by a plurality of contacts shown by dots in Figure 6.

With this arrangement, the portions 122 and 126 form a source region and a drain region of the n-channel transistor, respectively, and the portiond 124 and 128 form a source region and a drain region of the p-channel transistor, respectively.

Between another pair of adjacent input pads 24 and 26, there are formed a pair of n-channel transistor and p-channel transistor, in the same manner as those formed between the pair of adjacent input pads 22 and 24. However, explanation thereof will be omitted by adding the same Reference Numerals having the suffix "A" to corresponding elements.

Now, assume that the analog input pad 24 is selected, and a noise having a voltage lower than a ground level is inputted to the non-selected input pad 22. The n⁺ diffusion drain region 126 connected to the input pad 22 is biased in a forward direction to the p-substrate 20 maintained at the ground level. Therefore, electrons are injected into the substrate 20 from the n⁺ diffusion drain region 126 as illustrated in Figure 7. However, since the relatively deep N-well 102 is positioned between the n⁺ diffusion drain region 126 and the n⁺ diffusion drain region 126A connected to the selected input pad 24, a major portion of the electrons injected to the substrate 20 is absorbed by the N-well 102. Namely, the N-well 102 functions as a collector for electrons. The electrons absorbed by the N-well 102 are majority carriers within the N-well 102, and therefore, will flow into the channel stopper 110 and 112. Namely, the electrons absorbed by the N-well 102 will not exert any adverse influence. On the other hand, the amount of electrons absorbed to the n⁺ diffusion drain region 126A connected to the selected input pad 24 is remarkably decreased since the distance between the n⁺ diffusion drain region 126 connected to the non-selected input pad 22 and the n⁺ diffusion drain region 126A connected to the selected input pad 24 is elongated in comparison with that of the conventional one shown in Figure 3. According to the inventor's experiment, the amount of electrons absorbed to the n⁺ diffusion drain region 126A was decreased to about one-tenth of that of the conventional layout pattern.

On the other hand, assume that the analaog input pad 24 is selected and a noise having a voltage higher than Vcc is inputted into the analog pad 26. In this case, holes will be injected through the p⁺ diffusion region 128A to the N-well 102A. These injected holes are diffused within the N-well 102A, and further into the P-substrate 20. The holes injected into the substrate will be absorbed by the channel stoppers 106A and 108A. Therefore, no influence will appear. On the other hand, since, the p+ diffusion region 128 connected to the selected input pad 24 is formed within the N-well 102 which is independent of the N-well 102A injected with the holes, the holes which are majority carriers within the substrate 20 will not intrude into the N-well 102 because of a potential difference between the N-well 102 and the P-substrate 20. Therefore, the noise having a voltage higher than Vcc and inputted to a non-selected input pad is completely prevented

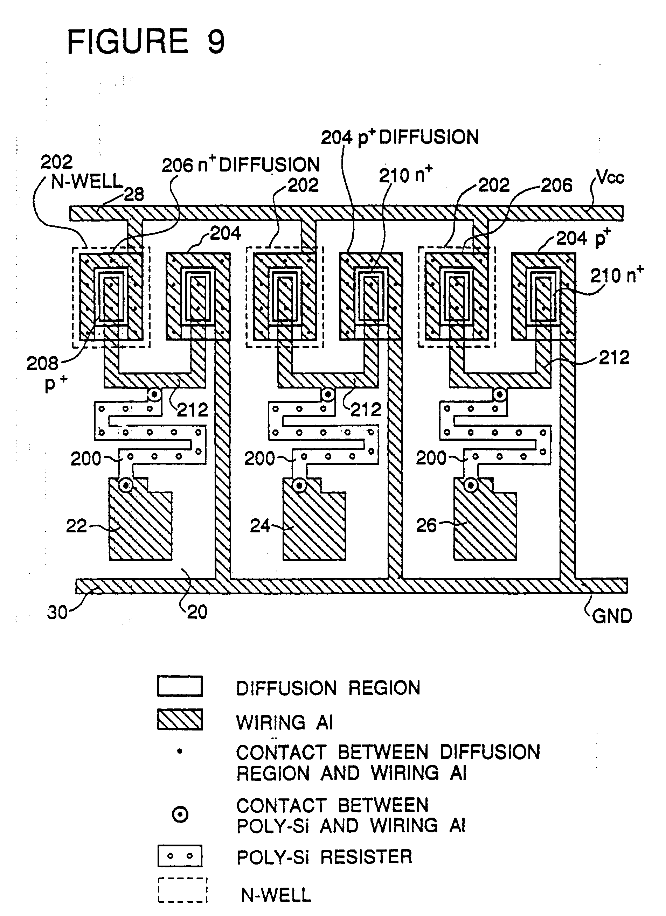

Turning to Figure 9, there is a layout pattern of another embodiment of the input protection circuit in accordance with the present invention, which realizes the input protection circuit shown in Figure 2A. Namely, each protection circuit is composed of a n⁺/p diode and a p⁺/n diode.

In the second embodiment, the P-substrate 20 includes a wiring conductor 28 of aluminum deposited along an upper edge of the substrate for a voltage supply potential Vcc, and another wiring conductor 30 of aluminum deposited along a lower edge of the substrate for ground GND.

Three input pads 22, 24 and 26 are formed on the substrate 20 separately from one another. Each of the input pads is connected to one end of a corresponding polysilicon resistor 200 also formed on the substrate 20.

The P-substrate 20 has N-wells 202 and p⁺ diffusion regions 204 which are located alternately in a direction along the Vcc wiring conductor 28 and in proximity of but separately from the Vcc wiring conductor 28. Within each of the N-wells 202, there is formed a n⁺ diffusion region 206 which is connected to the Vcc wiring conductor 28. Within the n⁺ diffusion region 206, furthermore, a p⁺ diffusion region 208 is formed, so that a p⁺/n diode is formed of the n⁺ diffusion region 206 and the p⁺ diffusion region 208. On the other hand, within the p⁺ diffusion region 204, an n⁺ diffusion region 210 is further formed, so that an n⁺/p diode is formed of the p⁺ diffusion region 204 and the n⁺ diffusion region 210. The p⁺ diffusion region 204 is connected to the ground wiring conductor 30. The p⁺ diffusion region 208 and the n⁺ diffusion region 210 are connected through a wiring conductor 212 to the other end of the corresponding resistor 200.

This arrangement can have the same effect in preventing the influence of a noise inputted to a non-selected input pad, as that obtained in the first embodiment. This will be easily understood from the explanation of the first embodiment, by considering the fact that the n-channel MOS transistor and the p-channel MOS transistor are replaced with the n⁺ diffusion region of the n⁺/p diode and the p⁺ diffusion region of the p⁺/n diode.

The invention has thus been shown and described with reference to the specific embodiments. However, it should be noted that the present invention is in no way limited to the details of the illustrated structures but changes and modifications may be made within the scope of the appended claims.

## Claims

1. A semiconductor integrated circuit with an input circuit having a plurality of input protection circuits for a corresponding number of input channels, the input circuit being formed on a semiconductor substrate, each of the input protection circuits comprising an analog input terminal to be connected to receive an analog voltage signal, a first semiconductor active clement formed within a first conduction type island formed in said semiconductor substrate, said first semiconductor active element having one end connected to said analog input terminal and a second end connected to a first wiring conductor for a positive voltage, said first semiconductor active element operating to discharge a positive excessive voltage to said first wiring conductor when said positive excessive voltage is applied to said analog input terminal, and a second semiconductor active element formed within a second conduction type island formed in said semiconductor substrate, said second conduction type being opposite to said first conduction type and said second semiconductor active element having one end connected to said analog input terminal and a second end connected to a second wiring conductor for ground, said second semiconductor active element operating to discharge a negative excessive voltage to said second wiring conductor when said negative excessive voltage is applied to said analog input terminal, said first semiconductor active elements and said second semiconductor active elements of all the input protection circuits being alternately located in the semiconductor substrate in such a manner that one first semiconductor active element is located between a pair of second semiconductor active elements and one second semiconductor active element is located between a pair of first semiconductor active elements.

2. A circuit claimed in Claim 1 wherein each of said first semiconductor active elements is constituted of a p-channel MOS transistor formed in an independent N-type island and having a drain connected to said analog input terminal and a gate and a source connected to said first wiring conductor, and each of said second semiconductor active elements is constituted of a n-channel MOS transistor formed in an independent P-type island and having a drain connected to said analog input terminal and a gate and a source connected to said second wiring conductor.

3. A circuit claimed in Claim 1 wherein each of said first semiconductor active elements is constituted of a first diode formed in an independent N-type island and having an anode connected to said analog input terminal and a cathode connected to said first wiring conductor, and each of said second semiconductor active elements is constituted of a second diode formed in an independent P-type island and having a cathode connected to said analog input terminal and an anode connected to said second wiring conductor.

4. An analog/digital converter in the form of an integrated circuit composed of complementary metal-oxide-semiconductor transistors formed on a semiconductor substrate, the analog/digital converter having a plurality of input channels which are composed of a corresponding number of input protection circuits formed on said semiconductor substrate, each of the input protection circuits comprising an analog input terminal to be connected to receive an analog voltage signal, a first semiconductor active element formed within a first conduction type island formed in said semiconductor substrate, said first semiconductor active element having one end connected to said analog input terminal and a second end connected to a first wiring conductor for a positive voltage, said first semiconductor active element operating to discharge a positive excessive voltage to said first wiring conductor when said positive excessive voltage is applied to said analog input terminal, and a second semiconductor active element formed within a second conduction type island formed in said semiconductor substrate, said second conduction type being opposite to said first conduction type and said second semiconductor active element having one end connected to said analog input terminal and a second end connected to a second wiring conductor for ground, said second semiconductor active element operating to discharge a negative excessive voltage to said second wiring conductor when said negative excessive voltage is applied to said analog input terminal, said first islands and said second islands for all the input protection circuits being alternately located in such a manner that one first island is located between a pair of second islands and one second island is located between a pair of first islands.

5. A circuit claimed in Claim 4 wherein said substrate is of P-type and each of said first islands is formed of an N-well formed within said P-type substrate and each of said second islands is formed of a portion of said P-type substrate itself, and wherein each of said first semiconductor active elements is constituted of a p-channel MOS transistor formed by p⁺ regions in said N-well, said p-channel MOS transistor having a drain connected to said analog input terminal and a gate and a source connected to said first wiring conductor, and each of said second semiconductor active elements is constituted of an n-channel MOS transistor formed by n⁺ regions in said second islands formed of said portion of said P-type substrate, said n-channel MOS transistor having a drain connected to said analog input terminal and a gate and a source connected to said second wiring conductor.

6. A circuit claimed in Claim 4 wherein said substrate is of P-type and each of said first islands is formed of a N-well formed within said P-type substrate and each of said second islands is formed of a p⁺ region formed within said P-type substrate itself, said N-well being independent of and separate from said p⁺ region, and wherein each of said first semiconductor active elements is constituted of a first diode formed in said N-well and having an anode connected to said analog input terminal and a cathode connected to said first wiring conductor, and each of said second semiconductor active elements is constituted of a second diode formed in said p⁺ region, and having a cathode connected to said analog input terminal and an anode connected to said second wiring conductor.

## Patentansprüche

1. Integrierte Halbleiterschaltung mit einer Eingangsschaltung, die eine Vielzahl von Eingangsschutzschaltungen für eine entsprechende Anzahl von Eingangskanälen aufweist, wobei die Eingangsschaltung auf einem Halbleitersubstrat ausgebildet ist, wobei jede der Eingangsschutzschaltungen einen Analog-Eingangsanschluß, der zum Empfangen eines analogen Spannungssignals zu verbinden ist, ein erstes aktives Halbleiterelement, das innerhalb einer in dem Halbleitersubstrat ausgebildeten Insel vom ersten Leitungstyp gebildet ist, wobei das erste aktive Halbleiterelement mit einem Ende mit dem Analog-Eingangsanschluß und dem zweiten Ende mit einem ersten Verdrahtungsleiter für eine positive Spannung verbunden ist, wobei das erste aktive Halbleiterelement arbeitet, um eine positive übermäßige Spannung an den ersten Verdrahtungsleiter abzuleiten, wenn die positive übermäßige Spannung an den Analog-Eingangsanschluß angelegt wird, und ein zweites aktives Halbleiterelement aufweist, das innerhalb einer in dem Halbleitersubstrat ausgebildeten Insel vom zweiten Leitungstyp gebildet ist, wobei der zweite Leitungstyp dem ersten Leitungstyp entgegengesetzt ist und wobei das zweite aktive Halbleiterelement mit einem Ende an dem Analog-Eingangsanschluß und dem zweiten Ende mit einem zweiten Verdrahtungsleiter für Masse verbunden ist, wobei das zweite aktive Halbleiterelement so arbeitet, daß es eine negative übermäßige Spannung an den zweiten Verdrahtungsleiter ableitet, wenn die negative übermäßige Spannung an den Analog-Eingangsanschluß angelegt wird, wobei die ersten aktiven Halbleiterelemente und die zweiten aktiven Halbleiterelemente aller Eingangsschutzschaltungen abwechselnd im Halbleitersubstrat in solcher Weise angeordnet sind, daß ein erstes aktives Halbleiterelement zwischen zwei zweiten aktiven Halbleiterelementen und ein zweites aktives Halbleiterelement zwischen zwei ersten aktiven Halbleiterelementen angeordnet ist.

2. Schaltung nach Anspruch 1, bei der jedes der ersten aktiven Halbleiterelemente durch einen p-Kanal-MOS-Transistor gebildet wird, der in einer unabhängigen Insel vom N-Typ ausgebildet ist und von dem die Senke mit dem Analog-Eingangsanschluß und das Gatter und die Quelle mit dem ersten Verdrahtungsleiter verbunden sind, und bei der jedes zweite aktive Halbleiterelement durch einen n-Kanal-MOS-Transistor gebildet ist, der in einer unabhängigen Insel vom P-Typ ausgebildet ist und von dem die Senke mit dem Analog-Eingangsanschluß und das Gatter und die Quelle mit dem zweiten Verdrahtungsleiter verbunden sind.

3. Schaltung nach Anspruch 1, bei der jedes der ersten aktiven Halbleiterelemente durch eine erste Diode gebildet ist, die in einer unabhängigen Insel vom N-Typ ausgebildet ist und von der die Anode mit dem Analog-Eingangsanschluß und die Kathode mit dem ersten Verdrahtungsleiter verbunden ist, und bei der jedes zweite aktive Halbleiterelement durch eine zweite Diode gebildet wird, die in einer unabhängigen Insel vom P-Typ ausgebildet ist und mit der Kathode mit dem Analog-Eingangsanschluß und mit der Anode mit dem zweiten Verdrahtungsleiter verbunden ist.

4. Analog/Digital-Wandler in Form einer integrierten Schaltung, die aus komplementären Metalloxid-Halbleitertransistoren aufgebaut ist, die auf einem Halbleitersubstrat ausgebildet sind, wobei der Analog/Digital-Wandler eine Vielzahl von Eingangskanälen aufweist, die aus einer entsprechenden Anzahl von Eingangsschutzschaltungen aufgebaut sind, die auf dem Halbleitersubstrat ausgebildet sind, wobei jede der Eingangsschutzschaltungen einen Analog-Eingangsanschluß, der zum Empfangen eines analogen Spannungssignals zu verbinden ist, ein erstes aktives Halbleiterelement, das innerhalb einer in dem Halbleitersubstrat ausgebildeten Insel vom ersten Leitungstyp gebildet ist, wobei das erste aktive Halbleiterelement mit einem Ende mit dem Analog-Eingangsanschluß und dem zweiten Ende mit einem ersten Verdrahtungsleiter für eine positive Spannung verbunden ist, wobei das erste aktive Halbleiterelement arbeitet, um eine positive übermäßige Spannung an den ersten Verdrahtungsleiter abzuleiten, wenn die positive übermäßige Spannung an den Analog-Eingangsanschluß angelegt wird, und ein zweites aktives Halbleiterelement aufweist, das innerhalb einer in dem Halbleitersubstrat ausgebildeten Insel vom zweiten Leitungstyp gebildet ist, wobei der zweite Leitungstyp dem ersten Leitungstyp entgegengesetzt ist und wobei das zweite aktive Halbleiterelement mit einem Ende an dem Analog-Eingangsanschluß und dem zweiten Ende mit einem zweiten Verdrahtungsleiter für Masse verbunden ist, wobei das zweite aktive Halbleiterelement so arbeitet, daß es eine negative übermäßige Spannung an den zweiten Verdrahtungsleiter ableitet, wenn die negative übermäßige Spannung an den Analog-Eingangsanschluß angelegt wird, wobei die ersten Inseln und die zweiten Inseln für alle Eingangsschutzschaltungen abwechselnd in solcher Weise angeordnet sind, daß eine erste Insel zwischen zwei zweiten Inseln und eine zweite Insel zwischen zwei ersten Inseln angeordnet ist.

5. Schaltung nach Anspruch 4, bei der das Substrat vom P-Typ ist und jede der ersten Inseln aus einer N-Mulde gebildet ist, die innerhalb des Substrats vom P-Typ angeordnet ist, und wobei jede zweite Insel aus einem Teil des Substrats vom P-Typ selbst gebildet ist, und bei der jedes der ersten aktiven Halbleiterelemente aus einem p-Kanal-MOS-Transistor gebildet ist, der durch p⁺-Bereiche in der N-Mulde gebildet ist, wobei der p-Kanal-MOS-Transistor mit der Senke mit dem Analog-Eingangsanschluß und dem Gatter und der Quelle mit dem ersten Verdrahtungsleiter verbunden ist, und wobei jedes der zweiten aktiven Halbleiterelemente durch einen n-Kanal-MOS-Transistor gebildet ist, der durch n⁺-Bereiche in den zweiten Inseln gebildet ist, die von dem Teil des Substrats vom P-Typ gebildet sind, wobei der n-Kanal-MOS-Transistor mit der Senke mit dem Analog-Eingangsanschluß und dem Gatter und der Quelle mit dem zweiten Verdrahtungsleiter verbunden ist.

6. Schaltung nach Anspruch 4, bei der das Substrat vom P-Typ ist und jede der ersten Inseln aus einer N-Mulde gebildet ist, die innerhalb des Substrats vom P-Typ gebildet ist, und wobei jede der zweiten Inseln aus einem p⁺-Bereich gebildet ist, der innerhalb des Substrats vom P-Typ selbst ausgebildet ist, wobei die N-Mulde unabhängig von und getrennt von dem p⁺-Bereich ist, und bei der jedes der ersten aktiven Halbleiterelemente durch eine erste Diode gebildet ist, die in der N-Mulde ausgebildet ist und mit der Anode mit dem Analog-Eingangsanschluß und mit der Kathode mit dem ersten Verdrahtungsleiter verbunden ist, und bei der jedes der zweiten aktiven Halbleiterelemente durch eine zweite Diode gebildet ist, die in dem p⁺-Bereich ausgebildet ist und deren Kathode mit dem Analog-Eingangsanschluß und deren Anode mit dem zweiten Verdrahtungsleiter verbunden ist.

## Revendications

1. Circuit intégré à semiconducteur avec un circuit d'entrée comportant une multitude de circuits de protection d'entrée pour un nombre correspondant de canaux d'entrée, le circuit d'entrée étant formé sur un substrat semiconducteur, chacun des circuits de protection d'entrée comprenant une borne d'entrée analogique qui devra être connecté afin de recevoir un signal de tension analogique, un premier élément actif semiconducteur formé à l'intérieur d'un îlot d'un premier type de conduction formé dans le substrat semiconducteur, le premier élément actif semiconducteur ayant une extrémité reliée à la borne d'entrée analogique et une seconde extrémité reliée à un premier conducteur de câblage pour une tension positive, le premier élément actif semiconducteur agissant pour décharger une tension positive excessive vers le premier conducteur de câblage lorsque la tension positive excessive est appliquée à la borne d'entrée analogique, et un second élément actif semiconducteur formé à l'intérieur d'un îlot d'un second type de conduction formé dans le substrat semiconducteur, le second type de conduction étant opposé au premier type de conduction et, le second élément actif semiconducteur ayant une extrémité reliée à la borne d'entrée analogique et une seconde extrémité reliée à un second conducteur de câblage destiné à la masse, le second élément actif semiconducteur agissant pour décharger les tensions excessives négatives vers le second conducteur de câblage lorsque la tension excessives négatives est impliquée à la borne d'entrée analogique, les premiers éléments actifs semiconducteur et les seconds éléments actif semiconducteurs de tous les circuits de protection d'entrée étant placés en alternance dans le substrat semiconducteur de manière telle qu'un premier élément actif semiconducteur est placé entre une paire d'un second élément actif semiconducteur et qu'un second élément actif semiconducteur est placé entre une paire de premiers éléments actifs semiconducteurs.

2. Circuit selon la revendication 1, dans lequel chacun des premiers éléments actifs semiconducteurs est constitué d'un transistor MOS à canal p formé dans un îlot indépendant de type N et ayant un drain relié à la borne d'entrée analogique et une grille et un source reliées au premier conducteur de câblage, et chacun des seconds éléments actifs semiconducteurs est constitué d'un transistor MOS à canal n formé dans un îlot de type P indépendant et ayant un drain relié à la borne d'entrée analogique et une grille et une source reliées au second conducteur de câblage.

3. Circuit selon la revendication 1 dans lequel chacun des premiers éléments actifs semi-conducteurs est constitué d'une première diode formée dans un îlot indépendant de type N et ayant une anode reliée à la borne d'entrée analogique et une cathode reliée au ler conducteur de câblage, et chacun des seconds éléments actifs semi-conducteurs est constitué d'une seconde diode formée dans un îlot indépendant de type P et ayant une cathode reliée à la borne d'entrée analogique et une anode reliée au second conducteur de câblage.

4. Convertisseur analogique/numérique sous la forme d'un circuit intégré constitué de transistors semi-conducteurs métalliques complémentaires formés sur un substrat semi-conducteur, le convertisseur analogique/numérique comportant une multitude de canaux d'entrée qui sont constitués d'un nombre correspondant de circuits de protection d'entrée formés sur les substrats semi-conducteurs, chacun des circuits de protection d'entrée comprenant une borne d'entrée analogique qui doit être connectée afin de recevoir un signal de tension analogique, un premier élément actif semi-conducteur formé à l'intérieur d'un îlot de premier type de conduction formé dans le substrat semi-conducteur, le premier élément actif semi-conducteur comportant une extrémité reliée à la borne d'entrée analogique et une seconde extrémité reliée à un premier conducteur de câblage destiné à tension positive, le premier élément actif semiconducteur agissant pour décharger une tension positive excessive, vers le premier conducteur de câblage lorsque la tension excessive positive est appliquée à la borne d'entrée analogique, et un second élément actif semiconducteur formé à l'intérieur d'un îlot d'un second type de conduction formé dans le substrat semiconducteur, le second type de conduction étant opposé au premier type de conduction et, le second élément actif semiconducteur ayant une extrémité reliée à la borne d'entrée analogique et une seconde extrémité reliée à un second conducteur de câblage destiné à la masse, les seconds éléments actifs semiconducteurs agissant pour décharger une tension excessive négative vers le second conducteur de câblage lorsque la tension excessive négative est appliquée à la borne d'entrée analogique, les premiers îlots et les seconds îlots pour tous les circuits de protection d'entrée étant placés en alternances de sorte qu'un premier îlot est placé entre une paire de seconds îlots et qu'un second îlot est placé entre une paire de premiers îlots.

5. Circuit selon la revendication 4, dans lequel le substrat est d'un type P et chacun des premiers îlots est formé d'un puits N formé à l'intérieur du substrat de type P et chacun des seconds îlots est formé d'une partie dudit substrat de type P lui-même, et dans lequel chacun des premiers éléments actifs semi-conducteurs est constitué dans transistor MOS à canal p formé par des régions p+ par le puits N, le transistor MOS à canal p ayant un drain relié à la borne d'entrée analogique et une grille et une source reliées au premier conducteur de câblage, et chacun des seconds éléments actifs semiconducteurs est constitué d'un transistor MOS à canal n formé par des régions n⁺ dans les seconds îlots formés de la partie du substrat de type P, le transistor MOS à canal N ayant un drain relié à la borne d'entrée analogique et une grille et une source reliées au second conducteur de câblage.

6. Circuit selon la revendication 4, dans lequel le substrat est du type P et chacun des premiers îlots est forme d'un puits N formé à l'intérieur du substrat de type P et chacun des seconds îlots est formé d'une région p⁺ formée à l'intérieur du substrat de type P lui-même. Le puits N étant indépendant et séparé de la région p⁺, et dans lequel chacun des premier éléments actifs semi-conducteurs est constitué d'une première diode formée dans le puits N et ayant une anode reliée à la borne d'entrée analogique et une cathode reliée au premier conducteur de câblage, et chacun des seconds éléments actifs semi-conducteurs est constitué d'une seconde diode formée dans la région p⁺, et ayant une cathode reliée à la borne d'entrée analogique et une anode reliée au second conducteur de câblage.
